(19) Europäisches Patentamt / European Patent Office / Office européen des brevets

(11) **EP 2 819 496 B1**

(12) **EUROPEAN PATENT SPECIFICATION**

(45) Date of publication and mention
of the grant of the patent:
**22.11.2017 Bulletin 2017/47**

(21) Application number: **12869413.0**

(22) Date of filing: **20.02.2012**

(51) Int Cl.:
***H05K 13/04*** (2006.01)

(86) International application number:
**PCT/JP2012/054022**

(87) International publication number:
**WO 2013/124959 (29.08.2013 Gazette 2013/35)**

(54) **PRODUCTION PLAN DETERMINING METHOD AND DETERMINING DEVICE**

VERFAHREN UND VORRICHTUNG ZUR FESTLEGUNG EINES PRODUKTIONSPLANS

MÉTHODE DE DÉTERMINATION DE PLAN DE PRODUCTION ET DISPOSITIF DE DÉTERMINATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.12.2014 Bulletin 2015/01**

(73) Proprietor: **Fuji Machine Mfg. Co., Ltd.**
**Chiryu-shi**
**Aichi 472-8686 (JP)**

(72) Inventor: **OTANE Shigenao**
**Chiryu-shi**
**Aichi 472-8686 (JP)**

(74) Representative: **Grünecker Patent- und Rechtsanwälte**
**PartG mbB**
**Leopoldstraße 4**
**80802 München (DE)**

(56) References cited:
**DE-A1-102008 020 167**    **JP-A- H11 251 796**
**JP-A- 2004 128 400**    **JP-A- 2007 103 734**
**US-A1- 2003 023 418**

**Description**

The present invention relates to a determination method and a determination apparatus for a production plan in a production process using an electronic component mounting apparatus.

An electronic component mounting apparatus is used as an apparatus which produces electronic circuit products by mounting electronic components on a circuit board. Then, when the electronic circuit products having multiple types are produced in a certain production line, the production is performed in accordance with a production plan configured to include the production of each electronic circuit product and a setup change corresponding to each production. The setup change includes an installation position of a component feeder installed in multiple slots or a nozzle mounted on a mounting head. For example, depending on the number of members to be replaced, the time required for the setup change varies. Therefore, even when the electronic circuit products having multiple types are produced, the time required for the overall production varies depending on the production order.

Therefore, an initial production plan is determined in view of factors such as types of the electronic components mounted on the respective electronic circuit products or a production time limit set for the production. For example, PTL 1 discloses a production method of improving the efficiency in the setup change. Further, PTL 3 and PTL 4 disclose methods for determining an initial production plan. In addition, in an actual production line, in some cases, interruption production is performed for an electronic circuit product which is different from that of the initial production plan. If the interruption production is performed, it is necessary to perform the setup change on the component feeder or the nozzle which has been used in the production before the interruption production, and also when the interruption production is completed, it is necessary to perform the setup change corresponding to the production after the interruption production. Therefore, for example, PTL 2 discloses a determination method for a setup change plan which shortens the time required for the setup change.

PTL 1: JP-A-2006-12946
PTL 2: JP-A-2011-146551
PTL 3: US 2003/023418 A1
PTL 4: DE 10 2008 020 167 A1

In addition, as described above, an overall production time period varies depending on the order in producing the electronic circuit products having multiple types. Therefore, depending on a position for interposing the interruption production between multiple production processes in the initial production plan, the time required for the setup change before and after the interruption production also varies, and consequently, the overall production time period is also affected. Therefore, a worker has empirically determined a production plan for the interposing position of the interruption production, for example, based on the types of electronic circuit products in the initial production plan or a production time limit set for the interruption production. Therefore, in some cases, the position of the interruption production in which the interruption production is interposed in the initial production plan is not necessarily optimal.

The present invention is made in view of the above-described problem, and an object thereof is to provide a determination method and a determination apparatus for a production plan, which can determine an efficient plan in interruption production by interposing the interruption production in an optimal position with respect to the production plan in which production is performed using an electronic component mounting apparatus.

(Determination Method for Production Plan)

According to the invention disclosed in Claim 1, in order to solve the above-described problem, there is provided a determination method for a production plan in which electronic circuit products having multiple types are produced, by using an electronic component mounting apparatus including multiple component feeders accommodating an electronic component, a nozzle corresponding to the electronic component, and a mounting head on which the nozzle is mounted and which is disposed to be relatively movable with respect to circuit boards, and by mounting the electronic component on each of the circuit boards having multiple types, in which the production plan includes a setup change corresponding to each production process, which targets at least one among the component feeders respectively installed in multiple slots, the nozzle installed in a nozzle station, the nozzle mounted on the mounting head, and the mounting head detachably disposed in the electronic component mounting apparatus. The determination method includes an interposing-available candidate search process in which an interposing-available candidate in which an interruption production can be interposed within an initial production plan is searched for, when the interruption production is performed for a different electronic circuit product in the initial production plan for the electronic circuit products having multiple types, a time calculation process for a prior/posterior setup change, in which time for the prior/posterior setup change which is required for the setup change before and after the interruption production when the interruption production is interposed in the interposing-available candidate is calculated for each searched for interposing-available candidate, based on the production before and after the interposing-available candidate and the interruption production, and a production plan determination process in which based on the time for the prior/posterior setup change with respect to the respective interposing-available candidates, one interposing-available candidate is selected, and the interruption production is interposed in the interposing-available candidate selected in the initial production plan so as to determine the production plan.

According to the invention disclosed in Claim 2, the determination method for a production plan further includes a time calculation process for interruption production in which an interruption production time period required for the interruption production when the interruption production is interposed in the interposing-available candidate is calculated for each of the searched interposing-available candidates, based on the production before the interposing-available candidate and the interruption production. In the production plan determination process, one interposing-available candidate is selected, based on the interruption production time period with respect to the respective interposing-available candidates.

According to the invention disclosed in Claim 3, the determination method for a production plan further includes an increased time calculation process in which the time required for the setup change corresponding to the production after the interposing-available candidate in the initial production plan and increased time in the prior/posterior setup change in the interposing-available candidate are calculated for each of the searched for interposing-available candidates. In the production plan determination process, one interposing-available candidate is selected, based on the increased time with respect to the respective interposing-available candidates.

According to the invention disclosed in Claim 4, the determination method for a production plan further includes a post-interruption time calculation process in which post-interruption time required for the setup change and the production after the interposing-available candidate when the interruption production is interposed in the interposing-available candidate is calculated for each of the searched for interposing-available candidates, based on the initial production plan and the interruption production. In the production plan determination process, based on the post-interruption time with respect to the respective interposing-available candidates, one interposing-available candidate is selected.

According to the invention disclosed in Claim 5, in the interposing-available candidate search process, the interposing-available candidate is searched for, based on a production time limit set in the initial production plan and the interruption production.

According to the invention disclosed in Claim 6, the production plan includes production for the electronic circuit product which is performed by multiple production lines using multiple electronic component mounting apparatuses. In the interposing-available candidate search process, the interposing-available candidate in which the interruption production can be interposed within the multiple initial production plans determined with respect to the respective production lines is searched for.

(Determination Apparatus for Production Plan)

According to the invention disclosed in Claim 7, in order to solve the above-described problem, there is provided a determination apparatus for a production plan in which electronic circuit products having multiple types are produced, by using an electronic component mounting apparatus including multiple component feeders accommodating an electronic component, a nozzle corresponding to the electronic component, and a mounting head on which the nozzle is mounted and which is disposed to be relatively movable with respect to circuit boards, and by mounting the electronic component on each of the circuit boards having multiple types, in which the production plan includes a setup change corresponding to each production process, which targets at least one among the component feeders respectively installed in multiple slots, the nozzle installed in a nozzle station, the nozzle mounted on the mounting head, and the mounting head detachably disposed in the electronic component mounting apparatus. The determination apparatus includes an interposing-available candidate search unit which searches for an interposing-available candidate in which the interruption production can be interposed within an initial production plan, when an interruption production is performed for a different electronic circuit product in the initial production plan for the electronic circuit products having multiple types, a time calculation unit for a prior/posterior setup change, which calculates time for the prior/posterior setup change which is required for the setup change before and after the interruption production when the interruption production is interposed in the interposing-available candidate for each searched for interposing-available candidate, based on the production before and after the interposing-available candidate and the interruption production, and a production plan determination unit which based on the time for the prior/posterior setup change with respect to the respective interposing-available candidates, selects one interposing-available candidate, and interposes the interruption production in the interposing-available candidate selected in the initial production plan so as to determine the production plan.

According to the invention disclosed in Claim 1, the time for the prior/posterior setup change when the interruption production is interposed in each interposing-available candidate in which the interruption production can be interposed within the initial production plan is calculated, and one interposing-available candidate is selected, based on the time for the prior/posterior setup change. In this manner, in view of the time required for the setup change corresponding to the interruption production and for the setup change corresponding to the production after the interruption production, it is possible to interpose the interruption production in the optimal position with respect to the initial production plan. This can reduce the influence on the overall production time period even when the interruption production is interposed therein. Thus, it is possible to determine an efficient interruption production plan.

According to the invention disclosed in Claim 2, in the production plan determination process, the interposing-available candidate is selected, based on the interruption production time period with respect to the respective interposing-available candidates. Here, as described above, the overall production time period varies depending on the order in producing the electronic circuit products having multiple types. However, the factor is considered as variations in the production time period required for each production process in addition to variations in the time for the setup change in the production plan. For example, when the optimal installation positions for the component feeder and the like are determined by using the method disclosed in PTL 2, these installation positions vary depending on a relationship between the prior and posterior production processes.

Then, in the electronic component mounting apparatus, the nozzle is moved to the component feeder so as to suck the electronic component. Accordingly, depending on the number of production processes for the electronic circuit products to be produced and the number of electronic components to be mounted, the variations in the installation position for the component feeder affect the production time period, in some cases. Therefore, the time for the interruption production is calculated for each of the interposing-available candidates. In this manner, in the production plan determination process, it is possible to interpose the interruption production in the optimal position with respect to the initial production plan in view of the time for the interruption production. This can reduce the influence on the overall production time period even when the interruption production is interposed therein.

According to the invention disclosed in Claim 3, in the production plan determination process, the interposing-available candidate is selected, based on the increased time in the time for the setup change with respect to the respective interposing-available candidates. In the initial production plan, if the interruption production is interposed in a certain interposing-available candidate, the setup change corresponding to the production after the interposing-available candidate is cancelled, and the setup change before and after the interruption production (the setup change corresponding to the interruption production and the setup change corresponding to the subsequent production described above) is added thereto. Therefore, in the present invention, the time for the cancelled setup change and the increased time in the prior/posterior setup change in the interposing-available candidate are calculated. In this manner, in the production plan determination process, it is possible to interpose the interruption production in the optimal position with respect to the initial production plan in view of the increased time. This can further reduce the influence on the overall production time period including the time for the setup change even when the interruption production is interposed therein.

According to the invention disclosed in Claim 4, in the production plan determination process, the interposing-available candidate is selected, based on the post-interruption time with respect to the respective interposing-available candidates. Here, as described above, the overall production time period varies depending on the order in producing the electronic circuit products having multiple types. However, depending on the interposing position of the interruption production, the installation positions for the component feeder and the like vary due to the setup change. The interposing position also affects the post-interruption time after the interruption production (time required for the setup change and the production), in some cases. Therefore, in the present invention, the post-interruption time is calculated for each of the interposing-available candidates. In this manner, in the production plan determination process, it is possible to interpose the interruption production in the optimal position with respect to the initial production plan in view of the post-interruption time. This can reduce the influence on the overall production time period even when the interruption production is interposed therein.

According to the invention disclosed in Claim 5, in the interposing-available candidate search process, when the interposing-available candidate in which the interruption production can be interposed within the initial production plan is searched for, the candidate is searched for, based on the production time limit set in each production process in the initial production plan and the interruption production. By adding this condition, it is possible to reliably prevent the interruption production itself from exceeding the production time limit due to the interposed interruption production. As described above, by narrowing down the interposing-available candidates in advance, it is possible to reduce a computational load in processes such as the subsequent time calculation process for the prior/posterior setup change. Accordingly, it is possible to shorten the time required until the production plan is determined.

According to the invention disclosed in Claim 6, in the interposing-available candidate search process, the multiple initial production plans determined with respect to the respective production lines are set to be search targets. Then, the interposing-available candidate in which the interruption production can be interposed within these initial production plans is searched for. In this manner, corresponding to the production plan in which the production is performed by the multiple production lines, it is possible to interpose the interruption production in the optimal position.

According to the invention disclosed in Claim 7, an advantageous effect which is the same as the above-described advantageous effect according to the invention disclosed in Claim 1 can be obtained. In addition, other features in the determination method for a production plan can also be similarly applied to the determination apparatus of the present invention. In this case, the same advantageous effect can be obtained.
[Fig. 1] Fig. 1 is a plan view of an electronic component mounting apparatus according to a first embodiment.
[Fig. 2] Fig. 2 is a block diagram illustrating a determination apparatus for a production plan.
[Fig. 3] Fig. 3 is a flowchart illustrating a determination process for a production plan.
[Fig. 4] Fig. 4 is a flowchart illustrating an interposing process for interruption production.
[Fig. 5] Fig. 5 is a flowchart illustrating a search process for an interposing-available candidate.
[Fig. 6] Fig. 6 is a time chart illustrating an initial production plan and an interruption production plan.
[Fig. 7] Fig. 7 is a flowchart illustrating a determination process for an interruption production plan.
[Fig. 8] Fig. 8 is a block diagram illustrating a determination apparatus for a production plan according to a second embodiment.
[Fig. 9] Fig. 9 is a flowchart illustrating an interposing process for interruption production.
[Fig. 10] Fig. 10 is a time chart illustrating an initial production plan and an interruption production plan.

Hereinafter, embodiments in which a determination method and a determination apparatus for a production plan are embodied according to the present invention will be described with reference to the drawings. Here, the production plan is determined with respect to one or more production lines, and is made in order to produce an electronic circuit product having multiple types by mounting electronic components on respective circuit boards having multiple types. In addition, in the above-described production line, for example, a cream solder printer (not illustrated) applies solder to a mounting position of the electronic component, and multiple mounting modules configuring an electronic component mounting apparatus are sequentially transported, and thereby mounting the electronic component thereon. Thereafter, the circuit board is soldered in a reflow furnace, and the electronic circuit product is manufactured.

<First Embodiment>

(Configuration of Electronic Component Mounting Apparatus 10)

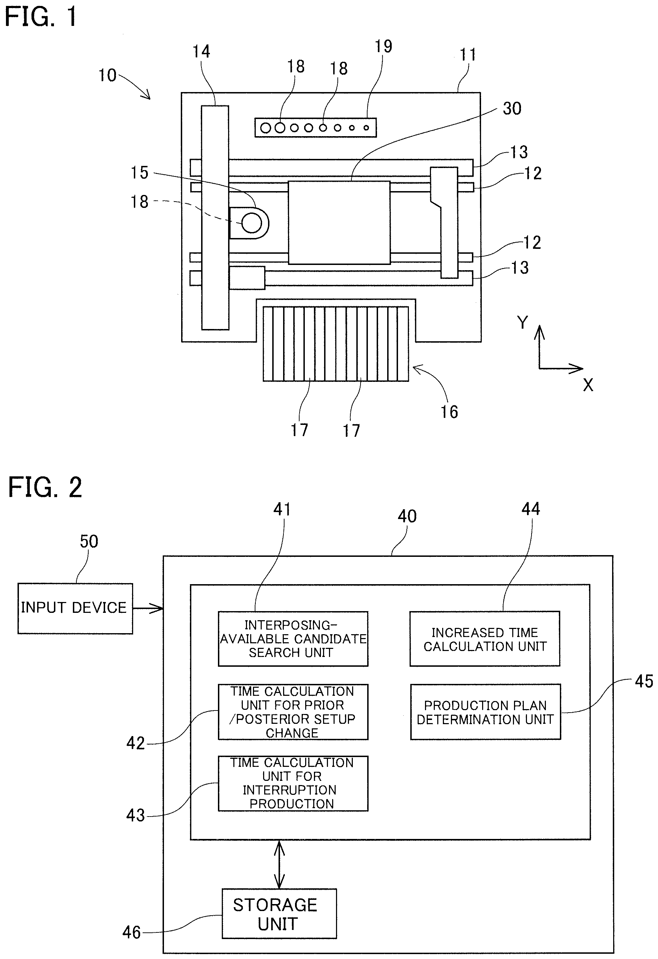

An electronic component mounting apparatus 10 to which a production plan is applied will be described with reference to Fig. 1. As illustrated in Fig. 1, the electronic component mounting apparatus 10 includes a base 11, a conveyor 12, a pair of X slide guides 13, an X slide body 14, a mounting head 15, multiple slots 16, a component feeder 17, a nozzle 18, and a nozzle station 19.
The base 11 is a base table fixed to the floor. The conveyor 12 is a transport device which is installed on an upper surface of the base 11 and transports a circuit board 30 placed on the conveyor 12 in an X direction. That is, the conveyor 12 sequentially transports multiple circuit boards 30 in a direction from -X to +X. The pair of X slide guides 13 are respectively installed on both outer sides of the conveyor 12 in a Y direction so as to extend in the X direction. The X slide body 14 is disposed so as to be suspended above the pair of X slide guides 13, and is disposed so as to be movable to the base 11 in the X direction.
The mounting head 15 is detachably disposed in the X slide body 14 so as to be movable to the X slide body 14 in the Y direction. That is, the mounting head 15 is movable to the base 11 in the X direction and the Y direction. More specifically, the mounting head 15 is relatively movable between the circuit board 30 transported on the conveyor 12 and the component feeder 17 (to be described later). The nozzle 18 is mounted on a lower end side of the mounting head 15 so as to be replaceable. In addition, the mounting head 15 may be a type mounting only one nozzle 18 or a type mounting multiple nozzles 18. These types are appropriately selected depending on a size of the electronic component to be mounted, the total number of electronic components, and the number of types thereof.
The multiple slots 16 are disposed on a side further outer than the conveyor 12 with respect to the X slide guide 13, in the base 11. Multiple component feeders 17 are respectively installed in the multiple slots 16. The component feeder 17 is a component carrier which accommodates the electronic component, and is illustrated as a tape feeder in the present embodiment. The component feeders 17 respectively accommodate one type of the electronic components.
The nozzle 18 is mounted on the lower end side of the mounting head 15. In order to mount multiple electronic components on the circuit board 30 transported on the conveyor 12, the nozzle 18 corresponds to the electronic component accommodated in the component feeder 17, and holds the electronic component by suction. That is, by moving the mounting head 15 in the X direction and the Y direction with respect to the base 11, the nozzle 18 can mount the electronic component accommodated in the component feeder 17 on the circuit board 30.
The nozzle station 19 is a storage place for multiple nozzles 18, in which multiple types of nozzle 18 which are not mounted on the mounting head 15 are installed. When the nozzle 18 to be mounted on the mounting head 15 is newly replaced, the mounting head 15 is moved to the nozzle station 19, the mounted nozzle 18 is detached from the nozzle station 19, and the other nozzle 18 stored in the nozzle station 19 is mounted thereon.

(Configuration of Determination Apparatus 40 for Production Plan)

Next, a determination apparatus 40 for a production plan which produces the electronic circuit product by using the above-described electronic component mounting apparatus 10, and a determination method thereof will be described with reference to Figs. 2 to 7. The production plan is determined with respect to the production line including the electronic component mounting apparatus 10, and is configured to include the production of the respective electronic circuit products on which the electronic components are mounted by the electronic component mounting apparatus 10, and a setup change corresponding to each production process.

As illustrated in Fig. 2, the determination apparatus 40 for the production plan includes an interposing-available candidate search unit 41 configured to have a CPU, for example, a time calculation unit for a prior/posterior setup change 42, a time calculation unit for interruption production 43, an increased time calculation unit 44, a production plan determination unit 45, and a storage unit 46 configured to have a RAM, for example. The storage unit 46 stores intermediate information calculated in the determination apparatus 40, and the initial production plan. In addition, for example, the determination apparatus 40 for the production plan acquires the information input by an input device 50 such as a keyboard, a pointing device, and a touch panel. Then, the determination apparatus 40 for the production plan prepares an interruption production plan by interposing the interruption production in the initial production plan, through processes described below.

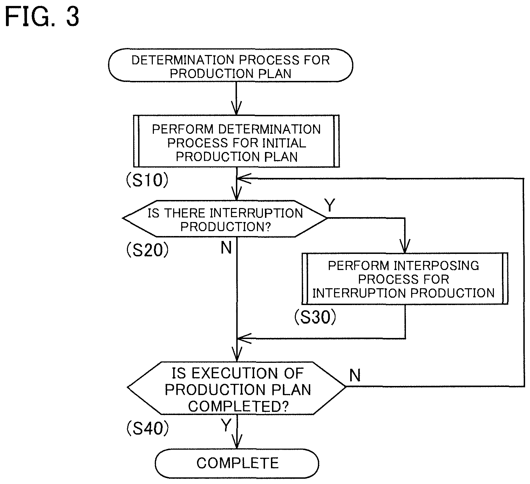

In a determination process for the production plan which is performed by the determination apparatus 40 for the production plan, as illustrated in Fig. 3, a determination process for an initial production plan PSe is first performed (S10). Here, the initial production plan PSe is determined in view of types of the electronic component to be mounted on the respective production-scheduled electronic circuit products or a production time limit set in the production. The initial production plan PSe includes the setup changes corresponding to each production process, if necessary, which target setup change members (the component feeders 17 respectively installed in the multiple slots 16, the nozzle 18 installed in the nozzle station 19, the nozzle 18 mounted on the mounting head 15, and the mounting head 15 detachably disposed in the electronic component mounting apparatus 10).

The setup change plan in the initial production plan PSe may be determined by using the known technology disclosed in JP-A-9-107197 or JP-A-11-87996, for example. That is, if there is no interruption production (to be described later), a position of the slots 16 in which the component feeder 17 in each production process is installed is determined so as to minimize the setup changes. In addition, in this setup change plan, the production time period required for each production process varies depending on the installation position of the setup change members or the like. In this regard, the setup change plan may be determined so as to minimize the setup changes in view of the production time period.

In addition, when the slot 16 for installing the component feeder 17 is determined and the multiple nozzles 18 which are different from each other can be mounted on the mounting head 15, multiple nozzle mounting units in the mounting head 15 and a storage position in the nozzle station 19 are chosen as the above-described slot 16. In this manner, it is possible to perform the determination process of the setup change plan by using the same process. Furthermore, in some cases, depending on the electronic component to be mounted, it is necessary to replace even the mounting head 15 detachably disposed in the X slide body 14 in the electronic component mounting apparatus 10. In addition, when the electronic component mounting apparatus 10 includes a head station for storing the multiple mounting heads 15, the head station is chosen as the above-described slot 16. In this manner, it is possible to perform the determination process of the setup change plan by using the same process.

After the production is started by the initial production plan PSe determined as described above, in the actual production line, there is a case where the interruption production is performed for the electronic circuit product which is different from that of the initial production plan PSe. In order to interpose the interruption production according to the interruption production in the initial production plan PSe, it is necessary to perform the setup change on the setup change members such as the component feeder 17 or the nozzle 18 before and after the interruption production. In addition, in some cases, the position where the interruption production is interposed between the multiple production processes in the initial production plan PSe affects the overall production time period. Therefore, the determination apparatus 40 for the production plan determines whether or not there is an interruption production (S20). Then, for example, when there is interruption production Xn (S20: Yes), the interposing process for the interruption production is performed so as to interpose the interruption production Xn in the optimal position with respect to the initial production plan PSe (S30).

Then, when there is no interruption production (S20: No), or if the interposing process for the interruption production is completed when there is an interruption production Xn (S30), it is determined whether or not all the production processes are completed (S40). When all the production processes are not completed (S40: No), the process returns to Step S20 again, and the production plan is repeatedly performed while it is determined whether or not there is an interruption production. In contrast, when all the production processes are completed (S40: Yes), the determination process for the production plan is completed.

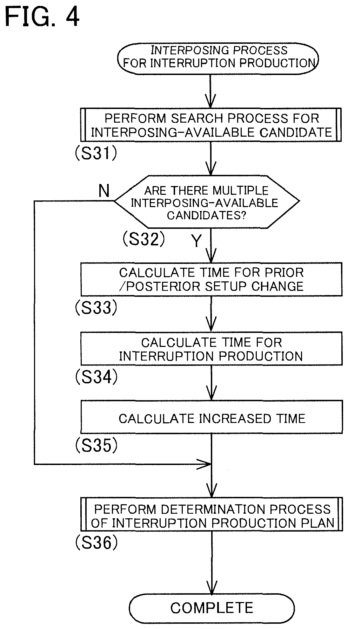

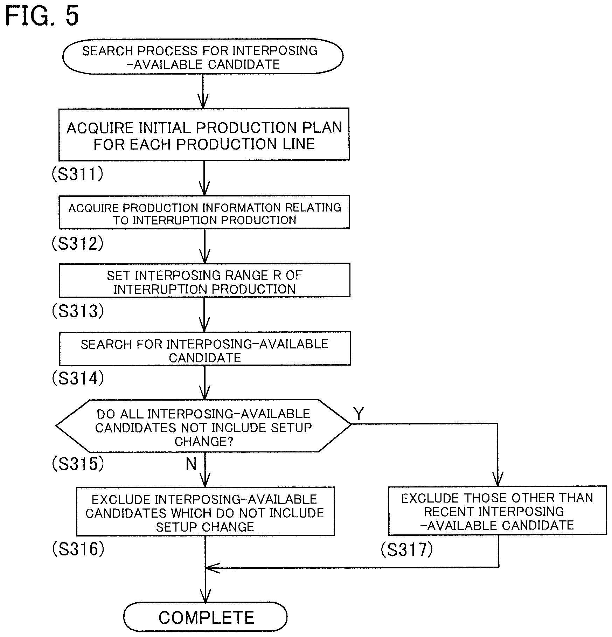

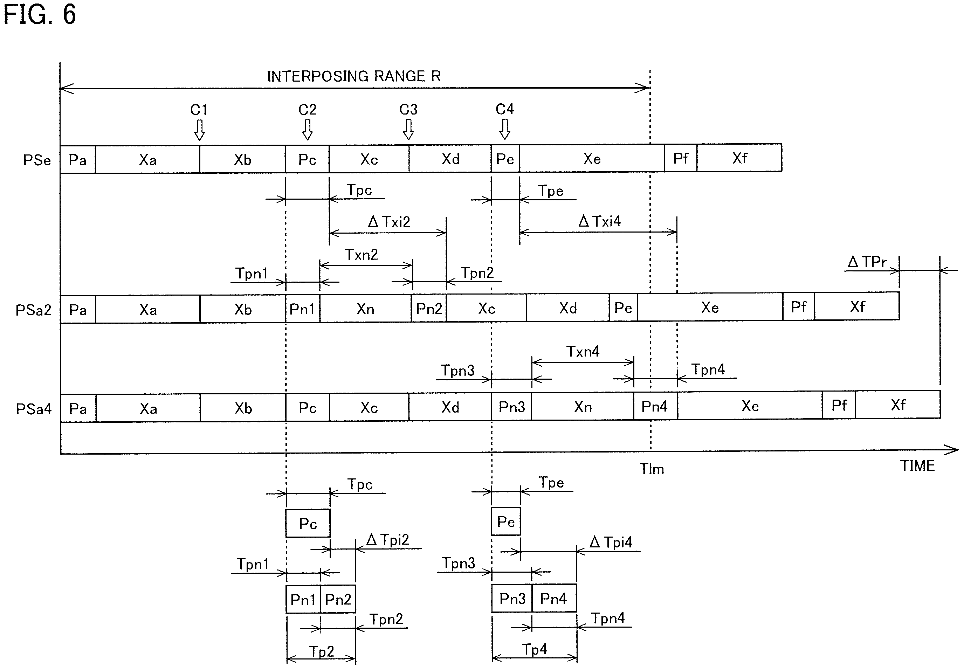

Next, the determination process for the interruption production plan will be described with reference to Figs. 4 to 7. In the process, as illustrated in Fig. 4, the interposing-available candidate search unit 41 first performs a search process for the interposing-available candidate in which the interruption production Xn can be interposed within the initial production plan PSe (S31). In the search process for the interposing-available candidate, as illustrated in Fig. 5, the initial production plan PSe for each production line is first acquired from the storage unit 46 (S311). In the present embodiment, the initial production plan PSe targets one production line. As illustrated in Fig. 6, the initial production plan PSe is configured to include production processes Xa to Xf and setup changes Pa, Pc, Pe, and Pf corresponding to the respective production processes Xa, Xc, Xe, and Xf. In the production processes Xb and Xd, the production process can be performed at the installation position where the setup change member is the same as the production processes Xa and Xc which are performed immediately before. Thus, the production processes do not require the setup change.

The interposing-available candidate search unit 41 acquires production information relating to the interruption production Xn from the storage unit 46 (S312). The production information includes a production time limit T1 set in the interruption production Xn, types of the electronic components to be mounted, and the number of products. Then, the interposing-available candidate search unit 41 sets an interposing range R, based on a currently progressed state of the initial production plan PSe, a production time limit set in each production process in the initial production plan PSe, and the production time limit T1 of the interruption production Xn (S313). The interposing range R is a range where a production completion time for the interruption production Xn necessarily fits in the initial production plan PSe. In addition, the production time limit T1 for the interruption production Xn may be set so that a predetermined production process previously included in the initial production plan PSe is designated and the production process thereof is completed earlier than the designated production process, for example. Even in this case, the interposing-available candidate search unit 41 sets the interposing range R by performing the same process. A start time limit which enables the interruption production Xn to be interposed in the initial production plan may be set. In this case, a start point of the interposing range R becomes the start time limit which enables the interruption production Xn to be interposed in the initial production plan.

Subsequently, an interposing-available candidate is searched for from those which are included in the interposing range R between the respective production processes in the initial production plan PSe (S314). Here, the production processes Xa to Xe are included in the interposing range R, and as illustrated in Fig. 6, interposing-available candidates C1 to C4 are searched. The interposing-available candidate search unit 41 determines whether the respective interposing-available candidates C1 to C4 include the setup change (S315). Here, there is no setup change in the production processes Xb and Xd immediately after the interposing-available candidates C1 and C3. However, there are setup changes Pc and Pe in the production processes Xc and Xe immediately after the interposing-available candidates C2 and C4 (S315: No). Therefore, the interposing-available candidates C1 and C3 which do not include the setup change are excluded from the interposing-available candidates C1 to C4 (S316). In this manner, the process is completed by regarding the result in the search process for the interposing-available candidate as the interposing-available candidates C2 and C4.

In contrast, for example, when all the interposing-available candidates do not include the setup change (S315: Yes), the interposing-available candidate C1 which is temporally the closest from the current time is left, and the other interposing-available candidates C2 to C4 are excluded (S317). Here, if the interruption production Xn is interposed in the initial production plan PSe, the production process and the setup change increase. Accordingly, the determination apparatus 40 for the production plan is configured to interpose the interruption production Xn preferentially between the production processes originally required for the setup change. This is intended to reduce the influence on the overall production time period after the interruption production Xn is interposed therein. However, when all the interposing-available candidates do not include the setup change (S315: Yes), even if the interruption production Xn is interposed in any interposing-available candidate, the setup change corresponding to the interruption production Xn causes the production time period to increase. Therefore, the interposing-available candidate is selected by narrowing down to those which are closest (S317).

Referring back to Fig. 4, in the interposing process for the interruption production, if the search process for the interposing-available candidate is completed (S31), it is determined whether the process result includes multiple interposing-available candidates (S32). When the process result does not include multiple interposing-available candidates (S32: No), the process proceeds to the determination process for the interruption production plan in Step S36. In contrast, when the process result of the search process for the interposing-available candidates includes multiple interposing-available candidates (S32: Yes), it is necessary to select one optimal interposing-available candidate from the multiple interposing-available candidates. Therefore, preparation for the above-described selection is performed through Steps S33 to S35. Here, since the process result includes the interposing-available candidates C2 and C4, the process proceeds to Step S33. Here, for the sake of convenience, it is assumed that the interruption production Xn is interposed in the interposing-available candidates C2 and C4. Interruption production plans PSa2 and PSa4 after being interposed therein are respectively illustrated in Fig. 6.

First, the time calculation unit for the prior/posterior setup change 42 calculates the time for the prior/posterior setup change for each searched for interposing-available candidate (S33). This "time for the prior/posterior setup change" is the time required for the setup change before and after the interruption production Xn when the interruption production Xn is interposed in a certain interposing-available candidate. That is, time for the prior/posterior setup change Tp2 when the interruption production Xn is interposed in the interposing-available candidate C2 is equivalent to a total sum of time Tpn1 required for a setup change Pn1 corresponding to the interruption production Xn and time Tpn2 required for a setup change Pn2 corresponding to the production process Xc, and is indicated by Expression 1(1) shown below. Time for the prior/posterior setup change Tp4 when the interruption production Xn is interposed in the similarly searched for interposing-available candidate C4 is equivalent to a total sum of time Tpn3 required for a setup change Pn3 corresponding to the interruption production Xn and time Tpn4 required for a setup change Pn4 corresponding to the production process Xe, and is indicated by Expression 1(2) shown below.

[Expression 1]

$$Tp2 = Tpn1 + Tpn2 \qquad (1)$$

$$Tp4 = Tpn3 + Tpn4 \qquad (2)$$

In addition, in the present embodiment, with regard to the prior setup changes Pn1 and Pn3 for the interruption production Xn, the prior setup change is optimized by using the same method as when the setup change plan in the initial production plan PSe is determined in Step S10. Furthermore, with regard to the posterior setup changes Pn2 and Pn4 for the interruption production Xn, that is, when the interruption production Xn is interposed in the interposing-available candidate C2 (C4), the setup change corresponding to the production process Xc (Xe) is determined so as to return to the installation position for the setup change which was previously determined by the setup change plan in the initial production plan PSe. That is, regardless of whether or not the interruption production Xn is interposed in the interposing-available candidate C2 (C4), the installation position for the setup change member in the production process Xc (Xe) immediately thereafter is configured so as not to vary.

Then, the time calculation unit for the prior/posterior setup change 42 calculates the time for the prior/posterior setup change Tp2, based on the production processes Xb and Xc before and after the interposing-available candidate C2 and the interruption production Xn, or calculates the time for the prior/posterior setup change Tp4, based on the production processes Xd and Xe before and after the interposing-available candidate C4 and the interruption production Xn. Here, both of the calculated times for the prior/posterior setup change Tp2 and Tp4 include the time required for the setup change corresponding to the interruption production Xn. However, the calculated times for the prior/posterior setup change Tp2 and Tp4 vary depending on the installation position for the setup change member or the like in the production process before and after the interposing-available candidates C2 and C4. Accordingly, the time for the prior/posterior setup change Tp2 has a value which is smaller than that of the time for the prior/posterior setup change Tp4 (Tp2<Tp4).

Next, the time calculation unit for the interruption production 43 calculates the time for the interruption production for each searched for interposing-available candidate (S34). This "time for the interruption production" is the time required for the production process when the interruption production Xn is interposed in a certain interposing-available candidate. Accordingly, the time calculation unit for the interruption production 43 calculates time for interruption production Txn2 (Txn4) when the interruption production Xn is interposed in the interposing-available candidate C2 (C4), based on the production process Xb (Xd) before the interposing-available candidate C2 (C4) and the interruption production Xn.

Here, both of the calculated times for the interruption production Txn2 and Txn4 are the times required for the interruption production Xn. However, depending on the installation position for the setup change member or the like in the production processes Xb and Xd before the interposing-available candidates C2 and C4, the installation position for the setup change member in the interruption production Xn varies. Therefore, the time for the interruption production Txn2 has a value which is smaller than that of the time for the interruption production Txn4 (Txn2<Txn4). This reason is because the electronic component mounting apparatus 10 causes the nozzle 18 to move to the component feeder 17 in order to suck the electronic component, and consequently, depending on the number of electronic circuit products to be manufactured and the number of the electronic components to be mounted, the variations in the installation position for the setup change member such as the component feeder 17 affect the times for the production Txn2 and Txn4.

Subsequently, the increased time calculation unit 44 calculates the increased time in the time for the prior/posterior setup change for each interposing-available candidate (S35). Here, if the interruption production Xn is interposed in a certain interposing-available candidate in the initial production plan PSe, the setup change corresponding to the production process after the interposing-available candidate is cancelled, and the setup change before the interruption production Xn and the setup change after the interruption production Xn are added. In addition, the time required for the cancelled setup change corresponds to the production process thereafter. Therefore, the times are different from each other.

In contrast, the increased time calculation unit 44 calculates time Tpc required for a setup change Pc cancelled in the interposing-available candidate C2 and increased time ΔTpi2 of time for the prior/posterior setup change Tp2 in the interposing-available candidate C2 which is calculated in Step 33. This increased time ΔTpi2 is indicated by Expression 2(3) shown below. Similarly, the increased time calculation unit 44 calculates the time required for the setup change Pe cancelled in the interposing-available candidate C4 and increased time ΔTpi4 in time for the prior/posterior setup change Tp4 in the interposing-available candidate C4. This increased time ΔTpi4 is indicated by Expression 2(4) shown below.
[Expression 2]

$$\Delta Tpi2 = Tp2 - Tpc \qquad (3)$$

$$\Delta Tpi4 = Tp4 - Tpe \qquad (4)$$

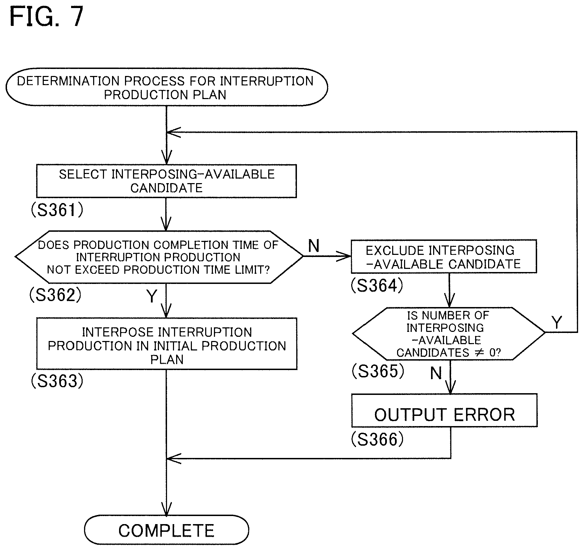

Thereafter, the production plan determination unit 45 performs a determination process for an interruption production plan (S36). In the determination process for the interruption production plan, as illustrated in Fig. 7, one interposing-available candidate is first selected (S361). In the present embodiment, the interposing-available candidates C2 and C4 are selected through the search process for the interposing-available candidates in Step 31. Therefore, the production plan determination unit 45 selects one interposing-available candidate, based on the increased times ΔTpi2 and ΔTpi4 relating to times for the prior/posterior setup change Tp2 and Tp4 relating to the interposing-available candidates C2 and C4, and times for the interruption production Txn2 and Txn4 of the interruption production Xn. Here, a total sum of the increased time ΔTpi2 relating to the interposing-available candidate C2 and the time for the interruption production Txn2 is smaller than a total sum of the increased time ΔTpi4 relating to the interposing-available candidate C4 and the time for the interruption production Txn4. Thus, the interposing-available candidate C2 is selected.

More specifically, as illustrated in Fig. 6, total increased time ΔTxi2 when the interruption production Xn is interposed in the interposing-available candidate C2 has a value which is smaller than that of total increased time ΔTxi4 when the interruption production Xn is interposed in the interposing-available candidate C4 (ΔTxi2<ΔTxi4). Thus, the interposing-available candidate C2 is selected. The above-described total increased times ΔTxi2 and ΔTxi4 are indicated by Expressions 3(5) and 3(6).
[Expression 3]

$$\Delta Txi2 = (Tp2 + Txn2) - Tpc \qquad (5)$$

$$\Delta Txi4 = (Tp4 + Txn4) - Tpe \qquad (6)$$

Next, the production plan determination unit 45 assumes that the interruption production Xn is interposed in the interposing-available candidate C2 selected in Step S361, and determines whether or not the production completion time of the interruption production Xn exceeds the production time limit T1 set in the interruption production Xn (S362). At this time, the above-described determination is performed, based on time Pn1 required for the setup change corresponding to the interruption production Xn which is calculated in Step S33, and the time for the interruption production Txn2 of the interruption production Xn which is calculated in Step S34. It is possible to improve the accuracy of the determination since the determination is performed based on these times. In the determination, when the production completion time does not exceed the production time limit T1 (S362: Yes), the production plan determination unit 45 interposes the interruption production Xn in the interposing-available candidate C2 selected in the initial production plan PSe, and determines the interruption production plan PSa2 (S363), thereby completing the determination process for the interruption production plan.

On the other hand, if the interruption production Xn is interposed in the currently selected interposing-available candidate, the production completion time exceeds the production time limit T1 (S362: No), and the interposing-available candidate serving as the target for the determination is excluded from the multiple interposing-available candidates (S364). Then, it is determined whether or not another interposing-available candidate remains (S365). When an interposing-available candidate remains (S365: Yes), the process returns to Step 361 again, and one selection candidate is selected. In addition, when another interposing-available candidate does not remain (S365: No), it is considered that the interruption production Xn cannot be interposed in the searched for interposing-available candidates. Accordingly, for example, an error is output to an operator so as to prompt a change of the conditions in searching for the interposing-available candidate (S366), and the determination process for the interruption production plan is completed. Then, the determination apparatus 40 causes the production plan determination unit 45 to complete the determination process (S36) for the interruption production plan, thereby completing the interposing process (S30) for the interruption production.

(Advantageous Effect Obtained by Determination Apparatus 40 for Production Plan)

According to the above-described determination apparatus 40 for the production plan, in the interposing process (S30) for the interruption production, the times for the prior/posterior setup change Tp2 and Tp4 when the interruption production Xn is interposed therein are calculated for each of the interposing-available candidates (C2 and C4) in which the interruption production Xn can be interposed within the initial production plan PSe (S33), and one interposing-available candidate is selected, based on the times for the prior/posterior setup change Tp2 and Tp4 (S36). In this manner, in view of the time required for the setup change corresponding to the interruption production Xn and the setup change corresponding to the production process after the interruption production Xn, it is possible to interpose the interruption production Xn in the optimal position with respect to the initial production plan PSe.

In addition, in the interposing process (S30) for the interruption production, the times for the interruption production Txn2 and Txn4 with respect to the respective interposing-available candidates C2 and C4 are calculated (S34), and the interposing-available candidate is selected based on the calculation result (S36). In this manner, in the determination process (S36) for the interruption production plan, in view of the times for the interruption production Txn2 and Txn4, it is possible to interpose the interruption production Xn in the optimal position with respect to the initial production plan PSe. This can further reduce the influence on the overall production time period, even when the interruption production Xn is interposed therein.

Furthermore, in the interposing process (S30) for the interruption production, the increased times $\Delta$Tpi2 and $\Delta$Tpi4 relating to the times for the setup change Tp2 and Tp4 with respect to the respective interposing-available candidates C2 and C4 are calculated (S35), and the interposing-available candidate is selected based on the calculation result (S36). In this manner, in the determination process (S36) for the interruption production plan, in view of the increased times $\Delta$Tpi2 and $\Delta$Tpi4, it is possible to interpose the interruption production Xn in the optimal position with respect to the initial production plan PSe.

Here, as illustrated in Fig. 6, a difference of $\Delta$TPr in the overall production time period arises between the interruption production plan PSa2 in which the interruption production Xn is interposed in the interposing-available candidate C2 and the interruption production plan PSa4 in which the interruption production Xn is interposed in the interposing-available candidate C4. $\Delta$TPr is equivalent to a difference between total increased times $\Delta$Txi2 and $\Delta$Txi4 when the interruption production Xn is interposed in each of the interposing-available candidates C2 and C4 ($\Delta$TPr = $\Delta$Txi4 - $\Delta$Txi2). As described above, even when the same interruption production Xn is interposed therein, the interposing position in the initial production plan PSe affects the overall production time period. Then, the determination apparatus 40 for the production plan according to the present embodiment interposes the interruption production in the optimal position, and thus, it is possible to reduce the influence on the overall production time period. Therefore, it is possible to determine the efficient interruption production plan.

In the search process (S31) for the interposing-available candidate, when the interposing-available candidate in which the interruption production Xn can be interposed within the initial production plan PSe is searched for, the interposing range R is set based on the production time limit T1 set in the individual production and the interruption production Xn in the initial production plan PSe (S313). Then, the interposing-available candidate is searched for under a condition that the interposing-available candidate is included in the interposing range R (S314). By adding this condition, it is possible to reliably prevent the interruption production itself from exceeding the production time limit T1 due to the interposed interruption production Xn. As described above, by narrowing down the interposing-available candidates in advance, it is possible to reduce a computational load in the subsequent time calculation process for the prior/posterior setup change or the like. Accordingly, it is possible to shorten the time required until the production plan is determined.

<Second Embodiment>

(Configuration of Determination Apparatus 140 for Production Plan)

A determination apparatus 140 for a production plan according to a second embodiment and a determination method using the determination apparatus 140 will be described with reference to Figs. 3, 4, and 8 to 10. The determination apparatus 140 for the production plan according to the present embodiment has a configuration different from that of the first embodiment, mainly in that the post-interruption time required for the setup change and the production process after the interposing-available candidate is calculated and one interposing-available candidate is selected based on the post-interruption time. The other common configurations are substantially the same as those in the first embodiment. Therefore, detailed description thereof will be omitted. Hereinafter, only the different points will be described.

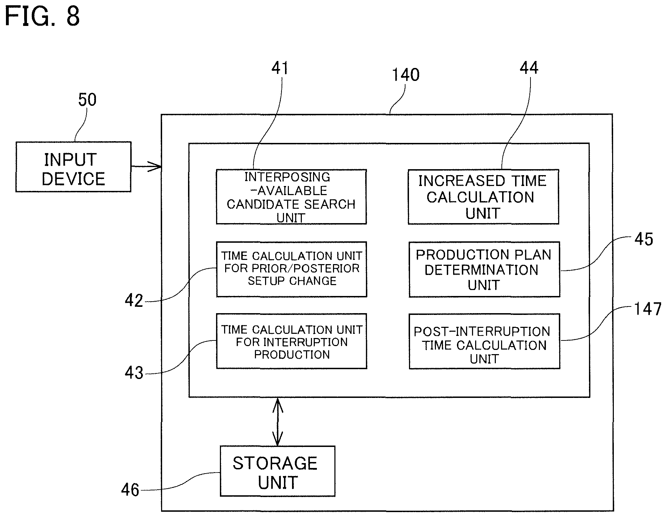

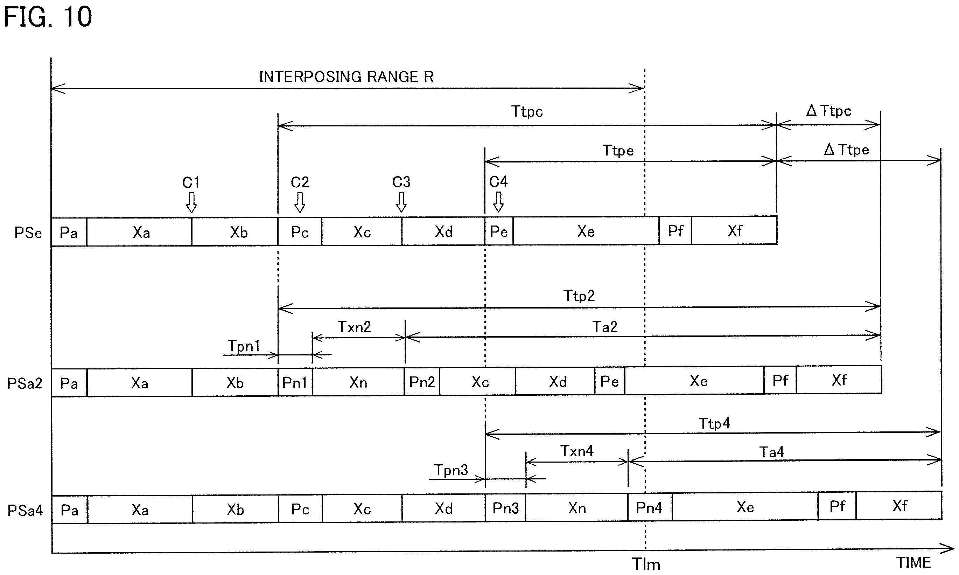

As illustrated in Fig. 8, the determination apparatus 140 for the production plan includes a post-interruption time calculation unit 147 in addition to the interposing-available candidate search unit 41, the time calculation unit for the prior/posterior setup change 42, the time calculation unit for the interruption production 43, the increased time calculation unit 44, the production plan determination unit 45, and the storage unit 46. The post-interruption time calculation unit 147 calculates the post-interruption time in the interposing process (S30) for the interruption production in Fig. 3. This "post-interruption time" is the time required for the setup change and the production process after the interposing-available candidate when the interruption production Xn is interposed in a certain interposing-available candidate. More specifically, as illustrated in Fig. 10, post-interruption time Ta2 when the interruption production Xn is interposed in the interposing-available candidate C2 is equivalent to a total sum of times respectively required for the setup changes Pn2, Pe, and Pf and times respectively required for the production processes Xc to Xf. Similarly, post-interruption time Ta4 when the interruption production Xn is interposed in the interposing-available candidate C4 is equivalent to a total sum of times respectively required for the setup changes Pn4 and Pf and times respectively required for the production processes Xe and Xf.

Incidentally, in the first embodiment, in Step S33 illustrated in Fig. 4, the time calculation unit for the prior/posterior setup change 42 calculates the time for the prior/posterior setup change which is required for the setup change before and after the interruption production Xn when the interruption production Xn is interposed in a certain interposing-available candidate. Then, in the setup change after the interruption production Xn, the post-setup change is determined so as to return to the installation position for the setup change which was previously determined by the setup change plan in the initial production plan PSe. That is, regardless of whether or not the interruption production Xn is interposed in the interposing-available candidate, the installation position for the setup change member in the production process immediately thereafter is configured so as not to vary.

In contrast, in the subsequent setup changes including the setup change after the interruption production Xn, the determination process (S10) for the initial production plan PSe is performed. In this manner, it is possible to further optimize the setup change plan by entirely reviewing the setup change plan. Therefore, in the present embodiment, in the interposing process (S30) for the interruption production, instead of the calculation of the time for the prior/posterior setup change, the post-interruption time is calculated.

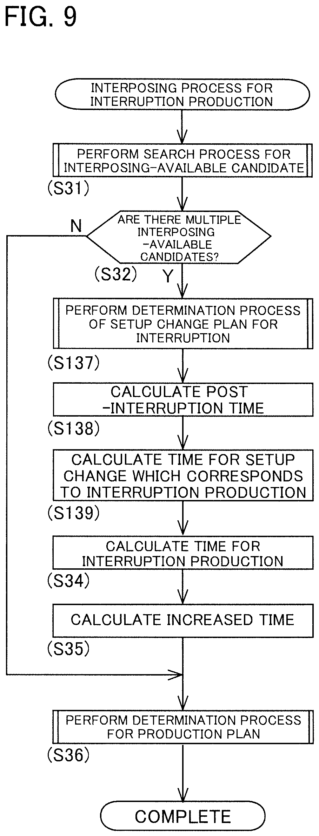

In the interposing process for the interruption production, as illustrated in Fig. 9, the interposing-available candidate search unit 41 first performs the search process for the interposing-available candidate in which the interruption production Xn can be interposed within the initial production plan PSe (S31). The process and Step S32 are the same as those in the first embodiment. Therefore, detailed description thereof will be omitted. Then, when the process result of the search process for the interposing-available candidate includes multiple interposing-available candidates (S32: Yes), it is necessary to select one optimal interposing-available candidate from the multiple interposing-available candidates. Therefore, preparation for the above-described selection is performed through Steps S137 to S139, S34, and S35. Here, the process result includes the interposing-available candidates C2 and C4, and thus, the process proceeds to Step S137.

The determination apparatus 140 for the production plan interposes the interruption production Xn in the respective interposing-available candidates by using the method which is the same as the determination method for the setup change plan in the initial production plan PSe, and thus, the determination process of the setup change plan for the interruption is performed for each of the interposing-available candidates C2 and C4 (S137). In this manner, the installation position for each setup change member or the like is determined by the setup changes Pn2, Pe, and Pf when the interruption production Xn is interposed in the interposing-available candidate C2. In this manner, an interruption production plan PSa2 is prepared. Similarly, the installation position for each setup change member or the like is determined by the setup changes Pn4 and Pf when the interruption production Xn is interposed in the interposing-available candidate C4. In this manner, an interruption production plan PSa4 is prepared.

As described above, if the installation position for the setup change member or the like is changed, the time for the setup change and the production time period vary accordingly, in some cases. Therefore, the post-interruption time calculation unit 147 calculates the post-interruption time Ta2 relating to the interposing-available candidate C2 and the post-interruption time Ta4 relating to the interposing-available candidate C4 (S138). Furthermore, the times for the setup change Tpn1 and Tpn3 which correspond to the interruption production Xn are calculated for each of the interposing-available candidates (C2 and C4) (S139). Subsequent Steps S34 and S35 are the same as those in the first embodiment. Therefore, detailed description thereof will be omitted.

Thereafter, the production plan determination unit 45 performs a determination process for an interruption production plan (S36). In the process, one interposing-available candidate is selected, based on the post-interruption times Ta2 and Ta4 relating to the interposing-available candidates C2 and C4, the production times Txn2 and Txn4 for the interruption production Xn, and the times for setup change Tpn1 and Tpn3 corresponding to the interruption production Xn. More specifically, the following comparison is performed. Total interruption production time Ttp2 required after the setup change Pn1 corresponding to the interruption production Xn when the interruption production Xn is interposed in the interposing-available candidate C2 is calculated. Similarly, total interruption production time Ttp4 required after the setup change Pn3 corresponding to the interruption production Xn when the interruption production Xn is interposed in the interposing-available candidate C4 is calculated. These total interruption production times Ttp2 and Ttp4 are indicated by Expressions 4(7) and 4(8) shown below.
[Expression 4]

$$Ttp2 = Tpn1 + Txn2 + Ta2 \qquad (7)$$

$$Ttp4 = Tpn3 + Txn4 + Ta4 \qquad (8)$$

Then, total initial production times Ttpc and Ttpe required after the setup changes Pc and Pe in the initial production plan are respectively calculated. Furthermore, a difference between the respectively corresponding total production times is obtained, and total increased production times $\Delta$Ttpc and $\Delta$Ttpe when the interruption production is interposed in the interposing-available candidates C2 and C4 are calculated. Then, the total increased production time $\Delta$Ttpc has a value which is smaller than that of the total increased production time $\Delta$Ttpe ($\Delta$Ttpc<$\Delta$Ttpe). Thus, the interposing-available candidate C2 is selected. The above-described total increased production times $\Delta$Ttpc and $\Delta$Ttpe are indicated by Expressions 5(9) and 5(10) shown below.
[Expression 5]

$$\Delta Ttpc = Ttp2 - Ttpc \qquad (9)$$

$$\Delta Ttpe = Ttp4 - Ttpe \qquad (10)$$

In this manner, in view of the post-interruption time required for the setup change and the production process after the interposing-available candidate, it is possible to select the interposing-available candidate. Then, the interruption production Xn is interposed in the interposing-available candidate in the initial production plan PSe, and the subsequent setup change plan is replaced by the setup change plan for interruption which is determined by Step S137, thereby completing the determination process for the interruption production plan. Other Steps are the same as those in the first embodiment. Therefore, detailed description thereof will be omitted.

According to the above-described determination apparatus 140 for the production plan, in the interposing process (S30) for the interruption production, the post-interruption times Ta2 and Ta4 with respect to the respective interposing-available candidates C2 and C4 are calculated, and one interposing-available candidate is selected based on the calculation result. In this manner, it is possible to optimize the setup change plan for interruption which corresponds to the interruption production Xn and the subsequent production process. Therefore, it is possible to more reliably determine a production plan having excellent production efficiency. Accordingly, it is possible to further reduce the influence on the overall production time period even when the interruption production Xn is interposed therein.

<Modification Example of First and Second Embodiments>

In the first and second embodiments, an aspect where the interruption production Xn is interposed therein by targeting the production plan determined for the production line including the electronic component mounting apparatus 10 has been described as an example. In contrast, the production plan may include production of the electronic circuit product which is performed by multiple production lines using multiple electronic component mounting apparatuses. That is, regarding multiple initial production plans PSe determined for each production line as a search target, the interposing-available candidate search unit 41 searches for an interposing-available candidate in which the interruption production Xn can be interposed within these initial production plans PSe. In this manner, it is possible to interpose the interruption production Xn in the optimal position by corresponding to the production plan in which the production is performed by the multiple production lines.

In addition, in the determination process of the production plan for interruption, one interposing-available candidate is selected, based on the time for the prior/posterior setup change, the time for the interruption production, the increased time, and the post-interruption time which are calculated for each interposing-available candidate (S361). Furthermore, for example, an allowable degree for the production time limit T1 of the interruption production Xn may be calculated for each interposing-available candidate, and one interposing-available candidate may be selected based on the calculation result. In the production line including the electronic component mounting apparatus 10, in some cases, the production is temporarily stopped due to the various reasons. Therefore, in a case where the interruption production Xn is completed on the verge of the production time limit T1, the temporary stop may affect even an efficient interruption production plan. Therefore, as described above, based on the allowable degree for the production time limit T1, one interposing-available candidate is selected. In this manner, the production time limit T1 of the interruption production Xn can have the efficiency and the allowable degree.

Reference Signs List

10 electronic component mounting apparatus

    11 base, 12 conveyor
    13 X slide guide
    14 X slide body
    15 mounting head
    16 slot
    17 component feeder
    18 nozzle
    19 nozzle station

30 circuit board
40 determination apparatus

    41 interposing-available candidate search unit
    42 time calculation unit for prior/posterior setup change
    43 time calculation unit for interruption production
    44 increased time calculation unit
    45 production plan determination unit
    46 storage unit
    147 post-interruption time calculation unit
    50 input device

## Claims

1. A determination method for a production plan in which electronic circuit products (30) having multiple types are produced,
by using an electronic component mounting apparatus (10) including multiple component feeders (17) accommodating an electronic component, a nozzle (18) corresponding to the electronic component, and a mounting head (15) on which the nozzle (18) is mounted and which is disposed to be relatively movable with respect to circuit boards (30), and
by mounting the electronic component on each of the circuit boards (30) having multiple types,
wherein the production plan includes a setup change corresponding to each production process, which targets at least one among the component feeders (17) respectively installed in multiple slots, the nozzle (18) installed in a nozzle station (19), the nozzle (18) mounted on the mounting head (15), and the mounting head (15) detachably disposed in the electronic component mounting apparatus (10), and
wherein the determination method **characterized by** comprising:

    an interposing-available candidate search process (S31) in which an interposing-available candidate in which an interruption production can be interposed within an initial production plan is searched for, when the interruption production is performed for a different electronic circuit product (30) in the initial production plan for the electronic circuit products (30) having multiple types;
    a time calculation process (S33) for a prior/posterior setup change, in which time for the prior/posterior setup change which is required for the setup change before and after the interruption production when the interruption production is interposed in the interposing-available candidate is calculated for each searched for interposing-available candidate, based on the production before and after the interposing-available candidate and the a production plan determination process (S36) in which based on the time for the prior/posterior setup change with respect to the respective interposing-available candidates, one interposing-available candidate is selected, and the interruption production is interposed in the interposing-available candidate selected in the initial production plan so as to determine the production plan.

2. The determination method for a production plan according to Claim 1, further comprising:

a time calculation process (S34) for interruption production in which an interruption production time period required for the interruption production when the interruption production is interposed in the interposing-available candidate is calculated for each of the searched interposing-available candidates, based on the production before the interposing-available candidate and the interruption production, wherein in the production plan determination process (S36), one interposing-available candidate is selected, based on the interruption production time period with respect to the respective interposing-available candidates.

3. The determination method for a production plan according to Claim 1 or 2, further comprising: an increased time calculation process (S35) in which the time required for the setup change corresponding to the production after the interposing-available candidate in the initial production plan and increased time in the prior/posterior setup change in the interposing-available candidate are calculated for each of the searched for interposing-available candidates, wherein in the production plan determination process (S36), one interposing-available candidate is selected, based on the increased time with respect to the respective interposing-available candidates.

4. The determination method for a production plan according to any one of Claims 1 to 3, further comprising: a post-interruption time calculation process (S138) in which post-interruption time required for the setup change and the production after the interposing-available candidate when the interruption production is interposed in the interposing-available candidate is calculated for each of the searched for interposing-available candidates, based on the initial production plan and the interruption production, wherein in the production plan determination process (S36), based on the post-interruption time with respect to the respective interposing-available candidates, one interposing-available candidate is selected.

5. The determination method for a production plan according to any one of Claims 1 to 4, wherein in the interposing-available candidate search process (S31), the interposing-available candidate is searched for, based on a production time limit set in the initial production plan and the interruption production.

6. The determination method for a production plan according to any one of Claims 1 to 5, wherein the production plan includes production for the electronic circuit product which is performed by multiple production lines using multiple electronic component mounting apparatuses (10), and wherein in the interposing-available candidate search process, the interposing-available candidate in which the interruption production can be interposed within the multiple initial production plans determined with respect to the respective production lines is searched for.

7. A determination apparatus for a production plan in which electronic circuit products (30) having multiple types are produced, by using an electronic component mounting apparatus (10) including multiple component feeders (17) accommodating an electronic component, a nozzle (18) corresponding to the electronic component, and a mounting head (15) on which the nozzle (18) is mounted and which is disposed to be relatively movable with respect to circuit boards (30), and by mounting the electronic component on each of the circuit boards (30) having multiple types, wherein the production plan includes a setup change corresponding to each production process, which targets at least one among the component feeders (17) respectively installed in multiple slots, the nozzle (18) installed in a nozzle station (19), the nozzle (18) mounted on the mounting head (15), and the mounting head (15) detachably disposed in the electronic component mounting apparatus (10), and wherein the determination apparatus **characterized by** comprising:

an interposing-available candidate search unit (41) adapted to search for an interposing-available candidate in which an interruption production can be interposed within an initial production plan, when the interruption production is performed for a different electronic circuit product (30) in the initial production plan for the electronic circuit products (30) having multiple types; a time calculation unit for a prior/posterior setup change (42) adapted to calculate time for the prior/posterior setup change which is required for the setup change before and after the interruption production when the interruption production is interposed in the interposing-available candidate for each searched for interposing-available candidate, based on the production before and after the interposing-available candidate and the interruption production; and

a production plan determination unit (45) adapted to select one interposing-available candidate based on the time for the prior/posterior setup change with respect to the respective interposing-available candidates, and to interpose the interruption production in the interposing-available candidate selected in the initial production plan so as to determine the production plan.

**Patentansprüche**

1. Verfahren zur Festlegung eines Produktionsplans, in dem Elektronikschaltkreis-Produkte (30) mit mehrfachen Typen produziert werden,

durch Verwenden einer Montagevorrichtung (10) elektronischer Bauelemente einschließlich mehrerer Komponentenzuführungseinrichtungen (17), die ein elektronisches Bauelement aufnehmen, eine dem elektronischen Bauelement entsprechende Düse (18) und einen Montagekopf (15), auf dem die Düse (18) angebracht ist und der so angeordnet ist, dass er bezüglich der Leiterplatten (30) relativ bewegbar ist, und

durch Montieren des elektronischen Bauelements auf jeder der Leiterplatten (30) mit mehrfachen Typen, wobei der Produktionsplan eine jedem Produktionsprozess entsprechende Einstellungsänderung umfasst, die zumindest auf eine aus der Zahl der Komponentenzuführungseinrichtungen (17), die jeweils in mehreren Schlitzen eingebaut sind, gerichtet ist; wobei die Düse (18) in einer Düsenstation (19) eingebaut ist, die Düse (18) an dem Montagekopf (15) angebracht ist und der Montagekopf (15) abnehmbar in der Montagevorrichtung (10) elektronischer Bauelemente angeordnet ist; und

wobei das Festlegungsverfahren **dadurch gekennzeichnet ist, dass** es umfasst:

einen Suchprozess (S31) zum Einfügen eines vorhandenen Anwärters, in dem nach einem zum Einfügen vorhandenen Anwärter, in den eine Unterbrechungsproduktion innerhalb eines ursprünglichen Produktionsplans eingefügt werden kann, gesucht wird, wenn die Unterbrechungsproduktion für ein anderes Elektronikschaltkreis-Produkt (30) in dem ursprünglichen Produktionsplan für die Elektronikschaltkreis-Produkte (30) mit mehrfachen Typen durchgeführt wird;

einen Zeitberechnungsprozess (S33) für eine frühere/spätere Einstellungsänderung, in dem Zeit berechnet wird für die frühere/spätere Einstellungsänderung, die zur Einstellungsänderung vor und nach der Unterbrechungsproduktion benötigt wird, wenn die Unterbrechungsproduktion in dem zum Einfügen vorhandenen Anwärter eingefügt wird, für jeden gesuchten, zum Einfügen vorhandenen Anwärter basierend auf der Produktion vor und nach dem zum Einfügen vorhandenen Anwärter und der Unterbrechungsproduktion berechnet wird; und

einen Prozess zur Festlegung eines Produktionsplans (S36), bei dem basierend auf der Zeit für die frühere/spätere Einstellungsänderung bezüglich der jeweiligen zum Einfügen vorhandenen Anwärter ein zum Einfügen vorhandener Anwärter ausgewählt wird, und die Unterbrechungsproduktion in dem im ursprünglichen Produktionsplan ausgewählten, zum Einfügen vorhandenen Anwärter eingefügt wird, um den Produktionsplan festzulegen.

2. Festlegungsverfahren für einen Produktionsplan nach Anspruch 1, des Weiteren umfassend:

einen Zeitberechnungsprozess (S34) für Unterbrechungsproduktion, bei dem eine für die Unterbrechungsproduktion benötigte Unterbrechungsproduktions-Zeitdauer, wenn die Unterbrechungsproduktion in dem zum Einfügen vorhandenen Anwärter eingefügt ist, für jeden der gesuchten, zum Einfügen vorhandenen Anwärter basierend auf der Produktion vor dem zum Einfügen vorhandenen Anwärter und der Unterbrechungsproduktion berechnet wird,

wobei in dem Produktionsplan-Festlegungsprozess (S36) ein zum Einfügen vorhandener Anwärter basierend auf der Unterbrechungsproduktions-Zeitdauer bezüglich der jeweiligen zum Einfügen vorhandenen Anwärter ausgewählt wird.

3. Festlegungsverfahren für einen Produktionsplan nach Anspruch 1 oder 2, des Weiteren umfassend: einen Mehrzeit-Berechnungsprozess (S35), bei dem die für die Einstellungsänderung benötigte Zeit, die der Produktion nach dem zum Einfügen vorhandenen Anwärter im ursprünglichen Produktionsplan entspricht, und Mehrzeit in der früheren/späteren Einstellungsänderung bei dem zum Einfügen vorhandenen Anwärter für jeden der gesuchten, zum Einfügen vorhandenen Anwärter berechnet werden,

wobei in dem Produktionsplan-Festlegungsprozess (S36) ein zum Einfügen vorhandener Anwärter basierend auf der Mehrzeit bezüglich der jeweiligen zum Einfügen vorhandenen Anwärter ausgewählt wird.

4. Festlegungsverfahren für einen Produktionsplan nach einem der Ansprüche 1 bis 3, des Weiteren umfassend: einen Nachunterbrechungszeit-Berechnungsprozess (S138), bei dem Nachunterbrechungszeit, die für die Einstellungsänderung und die Produktion nach dem zum Einfügen vorhandenen Anwärter benötigt wird, wenn die Unterbrechungsproduktion in dem zum Einfügen vorhandenen Anwärter eingefügt wird, für jeden der gesuchten, zum Einfügen vorhandenen Anwärter basierend auf dem ursprünglichen Produktionsplan und der Unterbrechungsproduktion berechnet wird,

   wobei in dem Produktionsplan-Festlegungsprozess (S36) basierend auf der Nachunterbrechungszeit bezüglich der jeweiligen zum Einfügen vorhandenen Anwärter ein zum Einfügen vorhandener Anwärter ausgewählt wird.

5. Festlegungsverfahren für einen Produktionsplan nach einem der Ansprüche 1 bis 4, wobei im Suchprozess (S31) des zum Einfügen vorhandenen Anwärters nach dem zum Einfügen vorhandenen Anwärter basierend auf einer im ursprünglichen Produktionsplan eingestellten Produktionszeitgrenze und der Unterbrechungsproduktion gesucht wird.

6. Festlegungsverfahren für einen Produktionsplan nach einem der Ansprüche 1 bis 5, wobei der Produktionsplan die Produktion für das Elektronikschaltkreis-Produkt umfasst, die durch mehrere Produktionslinien unter Verwendung mehrfacher Elektronikkomponenten-Montagevorrichtungen (10) ausgeführt wird, und

   wobei im Suchprozess des zum Einfügen vorhandenen Anwärters nach dem zum Einfügen vorhandenen Anwärter gesucht wird, in den die Unterbrechungsproduktion innerhalb der mehrfachen ursprünglichen Produktionspläne, die bezüglich der jeweiligen Produktionslinien festgelegt sind, eingefügt werden kann.

7. Festlegungsvorrichtung für einen Produktionsplan, in dem Elektronikschaltkreis-Produkte (30) mit mehrfachen Typen produziert werden,

   durch Verwendung einer Elektronikkomponenten-Montagevorrichtung (10) mit mehreren Komponentenzuführungseinrichtungen (17), die ein elektronisches Bauelement, eine dem elektronischen Bauelement entsprechende Düse (18) und einen Montagekopf (15) aufnehmen, auf dem die Düse (18) angebracht ist und der so angeordnet ist, dass er bezüglich der Leiterplatten (30) relativ bewegbar ist, und

   durch Montieren des elektronischen Bauelements auf jeder der Leiterplatten (30) mit mehrfachen Typen,

   wobei der Produktionsplan eine jedem Produktionsprozess entsprechende Einstellungsänderung umfasst, die auf zumindest eine aus der Zahl von Komponentenzuführungseinrichtungen (17), die jeweils in mehreren Schlitzen eingebaut sind, gerichtet ist; wobei die Düse (18) in einer Düsenstation (19) eingebaut ist, die Düse (18) an dem Montagekopf (15) angebracht ist und der Montagekopf (15) abnehmbar in der Elektronikkomponenten-Montagevorrichtung (10) angeordnet ist; und

   wobei die Festlegungsvorrichtung **dadurch gekennzeichnet ist, dass** sie umfasst:

       eine Sucheinheit (41) eines zum Einfügen vorhandenen Anwärters (41), die ausgelegt ist, nach einem zum Einfügen vorhandenen Anwärter zu suchen, in den eine Unterbrechungsproduktion innerhalb eines ursprünglichen Produktionsplans eingefügt werden kann, wenn die Unterbrechungsproduktion für ein anderes Elektronikschaltkreis-Produkt (30) in dem ursprünglichen Produktionsplan für die Elektronikschaltkreis-Produkte (30) mit mehrfachen Typen durchgeführt wird;

       eine Zeitberechnungseinheit für eine frühere/spätere Einstellungsänderung (42), die ausgelegt ist, Zeit für die frühere/spätere Einstellungsänderung zu berechnen, die benötigt wird für die Einstellungsänderung vor und nach der Unterbrechungsproduktion, wenn die Unterbrechungsproduktion in den zum Einfügen vorhandenen Anwärter für jeden gesuchten, zum Einfügen vorhandenen Anwärter eingefügt wird, basierend auf der Produktion vor und nach dem Einfügen des vorhandenen Anwärters und der Unterbrechungsproduktion; und

       eine Produktionsplan-Festlegungseinheit (45), die ausgelegt ist, einen zum Einfügen vorhandenen Anwärter basierend auf der Zeit für die frühere/spätere Einstellungsänderung bezüglich der jeweiligen zum Einfügen vorhandenen Anwärter auszuwählen und die Unterbrechungsproduktion in den zum Einfügen vorhandenen Anwärter, der im ursprünglichen Produktionsplanung ausgewählt ist, einzufügen, um den Produktionsplan festzulegen.

## Revendications

1. Procédé de détermination pour un plan de production dans lequel sont fabriqués des circuits électroniques (30) présentant des types multiples,
en utilisant un appareil de montage (10) de composants électroniques incluant de multiples dispositifs de délivrance de composants (17) accueillant un composant électronique, une buse (18) correspondant au composant électronique et une tête de montage (15) sur laquelle est montée la buse (18) et qui est disposée pour être mobile par rapport à des cartes à circuit imprimé (30), et
en montant le composant électronique sur chacune des cartes à circuit imprimé (30) présentant les types multiples, dans lequel le plan de production inclut un changement de structure correspondant à chaque processus de production, lequel cible au moins l'un parmi les dispositifs de délivrance de composants (18) installé respectivement dans de multiples emplacements, la buse (18) étant installée dans un poste de buses (19), la buse (18) étant montée sur la tête de montage (15) et la tête de montage (15) étant placée tout en pouvant être démontée dans l'appareil de montage (10) de composants électroniques, et
dans lequel le procédé de détermination est **caractérisé en ce qu'**il comprend :

un processus de recherche de candidat disponible à l'interposition (S31) dans lequel est recherché un candidat disponible à l'interposition dans lequel une production par interruption peut être intercalée dans le plan de production initial lorsque la production par interruption est effectuée pour un circuit électronique (30) différent dans le plan de production initial pour les circuits électroniques (30) présentant des types multiples,
un processus de calcul de temps (S33) pour un changement antérieur ou postérieur de structure dans lequel le temps défini pour le changement antérieur ou postérieur de structure qui est requis pour le changement de structure avant et après la production par interruption, lorsque la production par interruption est intercalée dans le candidat disponible à l'interposition, est calculé pour chaque candidat disponible à l'interposition recherché, sur la base de la production avant et après le candidat disponible à l'interposition et sur la production par interruption, et
un processus de détermination de plan de production (S36) dans lequel un premier candidat disponible à l'interposition est sélectionné, sur la base du temps défini pour le changement antérieur ou postérieur de structure par rapport aux candidats respectifs disponibles à l'interposition, et la production par interruption est intercalée dans le candidat disponible à l'interposition sélectionné dans le plan de production initial de sorte à définir le plan de production.

2. Procédé de détermination pour un plan de production selon la revendication 1, comprenant en outre : un processus de calcul de temps (S34) pour une production par interruption dans laquelle est calculé un intervalle de temps de production par interruption demandé pour la production par interruption lorsque la production par interruption est intercalée dans le candidat disponible à l'interposition, pour chacun des candidats recherchés disponibles à l'interposition, sur la base de la production avant le candidat disponible à l'interposition et sur la production par interruption, dans lequel, dans le processus de détermination de plan de production (S36), un candidat disponible à l'interposition est sélectionné, sur la base de l'intervalle de temps de production par interruption par rapport aux candidats respectifs disponibles à l'interposition.

3. Procédé de détermination pour un plan de production selon la revendication 1 ou la revendication 2, comprenant en outre : un processus de calcul de temps augmenté (S35) dans lequel sont calculés le temps demandé pour le changement de structure correspondante à la production après le candidat disponible à l'interposition dans le plan de production initial et le temps augmenté dans le changement antérieur ou postérieur de structure dans le candidat disponible à l'interposition, pour chacun des candidats recherchés disponibles à l'interposition, dans lequel, dans le processus de détermination de plan de production (S36), un candidat disponible à l'interposition est sélectionné, sur la base du temps augmenté par rapport aux candidats respectifs disponibles à l'interposition.

4. Procédé de détermination pour un plan de production selon l'une quelconque des revendications 1 à 3, comprenant en outre : un processus de calcul de temps post interruption (S138) dans lequel est calculé le temps post interruption demandé pour le changement de structure et la production après le candidat disponible à l'interposition lorsque la production par interruption est intercalée dans le candidat disponible à l'interposition, pour chacun des candidats disponibles à l'interposition, sur la base du plan de production initial et sur la production par interruption, dans lequel, dans le processus de détermination de plan de production (S36), un candidat disponible à l'interposition est sélectionné, sur la base du temps post interruption par rapport aux candidats respectifs disponibles à l'interposition.

5. Procédé de détermination pour un plan de production selon l'une quelconque des revendications 1 à 4, dans lequel, dans le processus de recherche de candidat disponible à l'interposition (S31), le candidat disponible à l'interposition est recherché sur la base d'une limite de temps de production établie dans le plan de production initial et sur la production par interruption.

6. Procédé de détermination pour un plan de production selon l'une quelconque des revendications 1 à 5, dans lequel le plan de production inclut une production pour le circuit électronique qui est effectuée par de multiples lignes de production utilisant de multiples appareils de montage (10) de composants électroniques, et

dans lequel, dans le processus de recherche de candidat disponible à l'interposition, est recherché le candidat disponible à l'interposition dans lequel la production par interruption peut être intercalée dans les plans de production initiaux déterminés par rapport aux lignes respectives de production.

7. Appareil de détermination pour un plan de production dans lequel sont produits des circuits électroniques (30) présentant des types multiples,

en utilisant un appareil de montage (10) de composants électroniques incluant de multiples dispositifs de délivrance de composants (17) accueillant un composant électronique, une buse (18) correspondant au composant électronique et une tête de montage (15) sur laquelle est montée la buse (18) et qui est disposée pour être mobile par rapport à des cartes à circuit imprimé (30), et

en montant le composant électronique sur chacune des cartes à circuit imprimé (30) présentant les types multiples, dans lequel le plan de production inclut un changement de structure correspondant à chaque processus de production, lequel cible au moins l'un parmi les dispositifs de délivrance de composants (18) installé respectivement dans de multiples emplacements, la buse (18) étant installée dans un poste de buses (19), la buse (18) étant montée sur la tête de montage (15) et la tête de montage (15) étant placée tout en pouvant être démontée dans l'appareil de montage (10) de composants électroniques, et

dans lequel l'appareil de détermination est **caractérisé en ce qu'**il comprend :

une unité de recherche de candidat disponible à l'interposition (41) conçue pour rechercher un candidat disponible à l'interposition dans lequel une production par interruption peut être intercalée dans le plan de production initial lorsque la production par interruption est effectuée pour un circuit électronique (30) différent dans le plan de production initial pour les circuits électroniques (30) présentant des types multiples,

une unité de calcul de temps (42) pour un changement antérieur ou postérieur de structure conçue pour calculer le temps défini pour le changement antérieur ou postérieur de structure qui est requis pour le changement de structure avant et après la production par interruption, lorsque la production par interruption est intercalée dans le candidat disponible à l'interposition pour chaque candidat disponible à l'interposition recherché, sur la base de la production avant et après le candidat disponible à l'interposition et sur la production par interruption, et

une unité de détermination de plan de production (45) conçue pour sélectionner un premier candidat disponible à l'interposition, sur la base du temps défini pour le changement antérieur ou postérieur de structure par rapport aux candidats respectifs disponibles à l'interposition, et pour intercaler la production par interruption dans le candidat disponible à l'interposition sélectionné dans le plan de production initial de sorte à définir le plan de production.

## FIG. 1

## FIG. 2

FIG. 3

```
        ┌─────────────────────────────────┐
        │  DETERMINATION PROCESS FOR      │
        │        PRODUCTION PLAN          │
        └─────────────────────────────────┘
                       │
                       ▼
        ┌─────────────────────────────────┐
        ║  PERFORM DETERMINATION          ║
        ║  PROCESS FOR INITIAL            ║
        ║  PRODUCTION PLAN                ║
        └─────────────────────────────────┘
   (S10)               │
                       ▼
        ╱─────────────────────────╲    Y
       ╱  IS THERE INTERRUPTION     ╲──────────┐
       ╲      PRODUCTION?           ╱          │
        ╲─────────────────────────╱           ▼
   (S20)        │ N           ┌───────────────────────────────┐
                │             ║  PERFORM INTERPOSING          ║
                │             ║  PROCESS FOR                  ║
                │             ║  INTERRUPTION PRODUCTION      ║
                │             └───────────────────────────────┘
                │                    (S30)      │
                │◄─────────────────────────────┘
                ▼
        ╱─────────────────────────╲    N
       ╱    IS EXECUTION OF         ╲──────────┐
       ╲    PRODUCTION PLAN         ╱          │
        ╲    COMPLETED?            ╱           │
         ╲─────────────────────╱               │
   (S40)        │ Y
                ▼
        ┌─────────────────────────────────┐
        │          COMPLETE               │
        └─────────────────────────────────┘
```

20

FIG. 4

```
        ┌─────────────────────────────────┐
        │      INTERPOSING PROCESS        │
        │  FOR INTERRUPTION PRODUCTION    │
        └─────────────────────────────────┘
                         │
                         ▼
        ╔═════════════════════════════════╗
        ║   PERFORM SEARCH PROCESS FOR    ║
        ║ INTERPOSING-AVAILABLE CANDIDATE ║
        ╚═════════════════════════════════╝
        (S31)
                         │
                         ▼
              ╱──────────────────────╲
         N   ╱   ARE THERE MULTIPLE   ╲
     ◄──────◄  INTERPOSING-AVAILABLE   ►
              ╲      CANDIDATES?       ╱
               ╲────────────────────╱
        (S32)          Y │
                         ▼
        ┌─────────────────────────────────┐
        │    CALCULATE TIME FOR PRIOR     │
        │    /POSTERIOR SETUP CHANGE      │
        └─────────────────────────────────┘
        (S33)
                         │
                         ▼
        ┌─────────────────────────────────┐
        │       CALCULATE TIME FOR        │
        │    INTERRUPTION PRODUCTION      │
        └─────────────────────────────────┘
        (S34)
                         │
                         ▼
        ┌─────────────────────────────────┐
        │    CALCULATE INCREASED TIME     │
        └─────────────────────────────────┘
        (S35)
                         │
                         ▼
        ╔═════════════════════════════════╗
        ║  PERFORM DETERMINATION PROCESS  ║
        ║ OF INTERRUPTION PRODUCTION PLAN ║
        ╚═════════════════════════════════╝
        (S36)
                         │
                         ▼
        ┌─────────────────────────────────┐
        │           COMPLETE              │
        └─────────────────────────────────┘
```

# FIG. 5

```
┌──────────────────────────────────────┐
│  SEARCH PROCESS FOR INTERPOSING      │
│      -AVAILABLE CANDIDATE            │
└──────────────────────────────────────┘
                 │
                 ▼
┌──────────────────────────────────────┐
│  ACQUIRE INITIAL PRODUCTION PLAN     │
│     FOR EACH PRODUCTION LINE         │
└──────────────────────────────────────┘
(S311)
                 │
                 ▼
┌──────────────────────────────────────┐
│ ACQUIRE PRODUCTION INFORMATION RELATING │
│       TO INTERRUPTION PRODUCTION     │
└──────────────────────────────────────┘
(S312)
                 │
                 ▼
┌──────────────────────────────────────┐
│      SET INTERPOSING RANGE R OF      │
│       INTERRUPTION PRODUCTION        │
└──────────────────────────────────────┘
(S313)
                 │
                 ▼
┌──────────────────────────────────────┐
│   SEARCH FOR INTERPOSING-AVAILABLE   │
│            CANDIDATE                 │
└──────────────────────────────────────┘
(S314)
                 │
                 ▼
         DO ALL INTERPOSING-AVAILABLE        Y
         CANDIDATES NOT INCLUDE SETUP  ───────────────┐
                 CHANGE?                               │
(S315)           N│                                    │
                  ▼                                    ▼
┌──────────────────────────────┐    ┌──────────────────────────────┐
│ EXCLUDE INTERPOSING-AVAILABLE │    │  EXCLUDE THOSE OTHER THAN     │
│ CANDIDATES WHICH DO NOT INCLUDE│   │    RECENT INTERPOSING         │
│        SETUP CHANGE          │    │    -AVAILABLE CANDIDATE       │
└──────────────────────────────┘    └──────────────────────────────┘
(S316)                                  (S317)
                  │◄─────────────────────────────────┘
                  ▼
          ┌──────────────────┐
          │    COMPLETE      │
          └──────────────────┘
```

22

FIG. 6

EP 2 819 496 B1

# FIG. 7

DETERMINATION PROCESS FOR INTERRUPTION PRODUCTION PLAN

SELECT INTERPOSING-AVAILABLE CANDIDATE
(S361)

DOES PRODUCTION COMPLETION TIME OF INTERRUPTION PRODUCTION NOT EXCEED PRODUCTION TIME LIMIT? — N → EXCLUDE INTERPOSING-AVAILABLE CANDIDATE (S364)
(S362) Y

INTERPOSE INTERRUPTION PRODUCTION IN INITIAL PRODUCTION PLAN
(S363)

IS NUMBER OF INTERPOSING-AVAILABLE CANDIDATES ≠ 0? — Y
(S365) N

OUTPUT ERROR
(S366)

COMPLETE

# FIG. 8

50
INPUT
DEVICE

41    140    44

INTERPOSING
-AVAILABLE
CANDIDATE SEARCH
UNIT

INCREASED TIME
CALCULATION
UNIT

42
TIME CALCULATION UNIT
FOR PRIOR/POSTERIOR
SETUP CHANGE

PRODUCTION PLAN
DETERMINATION
UNIT
45

43
TIME CALCULATION UNIT
FOR INTERRUPTION
PRODUCTION

POST-INTERRUPTION
TIME CALCULATION
UNIT
147

46
STORAGE
UNIT

# FIG. 9

INTERPOSING PROCESS FOR
INTERRUPTION PRODUCTION

PERFORM SEARCH PROCESS FOR
INTERPOSING–AVAILABLE CANDIDATE
(S31)

ARE THERE MULTIPLE
INTERPOSING
–AVAILABLE
CANDIDATES?
(S32)    Y    N

PERFORM DETERMINATION PROCESS
OF SETUP CHANGE PLAN FOR
INTERRUPTION
(S137)

CALCULATE POST
–INTERRUPTION TIME
(S138)

CALCULATE TIME FOR SETUP
CHANGE WHICH CORRESPONDS
TO INTERRUPTION PRODUCTION
(S139)

CALCULATE TIME FOR
INTERRUPTION PRODUCTION
(S34)

CALCULATE INCREASED TIME
(S35)

PERFORM DETERMINATION PROCESS
FOR PRODUCTION PLAN
(S36)

COMPLETE

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006012946 A
- JP 2011146551 A
- US 2003023418 A1
- DE 102008020167 A1
- JP 9107197 A
- JP 11087996 A